# EUROPEAN PATENT APPLICATION

(11) **EP 0 942 628 A2**
(43) Date of publication of application: **15.09.1999**
(21) Application number: 99301913.2
(22) Date of filing: 12.03.1999
(51) Int. Cl.: H04R 25/00

(54) **Microphone assembly and calibration method**

(30) Priority: 13.03.1998 US 41870
(71) Applicant: SIEMENS HEARING INSTRUMENTS, INC., Piscataway, NJ 08854 (US)
(72) Inventor: Chojar, Sunil, Lebanon, NJ 08833 (US); Saltykov, Oleg, Fairlawn, NJ 07401 (US)
(74) Representative: Litchfield, Laura Marie

(57) **Abstract**

Two hearing aid microphones are mounted to a substrate, which may be a printed circuit. Electrical components may also be mounted on the substrate. The resulting assembly is easier to handle and reduces assembly time and the dexterity that has previously been required of manufacturing personnel. A method for calibrating the microphone assembly of the invention is also disclosed.

## Description

The invention relates to hearing aids, and more particularly relates to directional hearing aids. In its most immediate sense, the invention relates to the two microphones that are used in a directional hearing aid.

Known hearing aids have only one microphone, which is usually omnidirectional. This has the disadvantage that the aid does not respond to the directionality of incoming sound, as does a properly functioning human ear. As a result, speech intelligibility is diminished.

Directional hearing aids were developed to overcome this disadvantage. A directional hearing aid uses two microphones so the patient can ascertain the directionality of sounds. Usually one microphone is forward of the other. In use, the sound output of the hearing aid is caused to depend upon the direction of the sound input to the hearing aid; sounds coming from the rear produce a minimum output (ideally, a zero output), sounds coming from the front produce a maximum output, and sounds coming from the side produce an output that is between the minimum and the maximum. By learning how this dependency works, the patient can learn to distinguish between e.g. sounds from in front of the patient and sounds from behind the patient.

For a directional hearing aid to perform properly, the microphones must be properly positioned. And, because the microphones are usually individually mounted to the faceplate and individually connected to the hearing aid circuitry, such positioning requires time and manual dexterity. This consequently increases manufacturing expense. Additionally, directional aids have not performed properly unless the microphones have matching characteristics, i.e unless they have similar sensitivity, phase and frequency response. This requires extra testing of the microphones and matching them to each other. Such effort is not expensive merely because of the time and effort required, but because of the cost of microphones that cannot be matched and must therefore be rejected.

Although these problems have been recognized, they have not been satisfactorily solved. In the D-MIC manufactured by Etymotic Research (Elk Grove Village, IL) one directional microphone and one omnidirectional microphone are mounted in a common ported cartridge. The cartridge is too large for use in canal aids, and is even too large for many In-The-Ear (ITE) aids.

Another unsatisfactory solution is a type of directional microphone that is formed from a single microphone unit provided with two sound input ports. Such microphones have not worked well.

It would be advantageous to make it easier and less expensive to mount and connect the two microphones in a directional hearing aid.

It would further be advantageous to avoid the need for matched microphones in a directional hearing aid.

In accordance with the invention, two hearing aid microphones are mechanically fixed to a substrate. It is therefore unnecessary to handle the microphones individually.

In accordance with the preferred embodiment, the substrate is a printed circuit to which the microphones are electrically connected, and electrical components such as resistors and capacitors are mounted to the substrate.

Further advantageously, some components can be adjustable (i.e. can be trimmers or other devices in which the value of the component can be changed). These components can be used to modify the characteristics of one of the microphones to match the other one.

For a better understanding of the present invention, and to show how it may be brought into effect, reference will now be made, by way of example, to the accompanying drawings, in which:
Fig. 1 is a schematic illustration of a preferred embodiment of the invention;
Fig. 2 is an exemplary schematic diagram illustrating the principle of operation of the preferred embodiment;
Fig. 3 is an exemplary schematic diagram of a circuit in accordance with the preferred embodiment of the invention; and
Fig. 4 is a flow chart illustrating a method in accordance with the preferred embodiment.

Two hearing aid electret-type microphones 2 and 4 are provided. Each of the microphones has three electrodes (2A, 2B, 2C and 4A, 4B, 4C, respectively). The microphones 2 and 4 are mechanically fixed to a substrate 6. Advantageously, this is accomplished by making the substrate 6 of a KAPTON- or MYLAR-based printed circuit and soldering (as by wave soldering) the electrodes 2A, 2B, 2C, 4A, 4B, 4C thereto. Ordinarily, the microphones 2 and 4 are spaced apart by a minimum of 10 mm.

It will be understood that the above-described assembly can be manufactured by machinery, without the need for hand labour. The assembly is sufficiently small that it can be used in canal aids. And, because the above-described assembly is large in comparison with the microphones 2 and 4, it is much easier to handle and to install in a hearing aid.

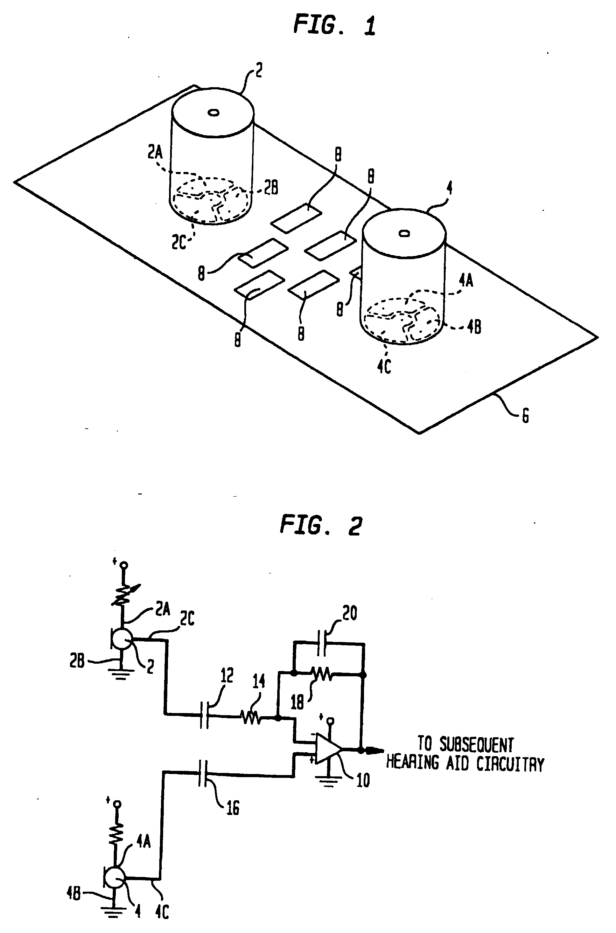

Advantageously, components 8 are also mounted to the substrate 6 to form circuitry. The principle of operation of that circuitry will be discussed with reference to Fig. 2, in which the rear microphone is indicated by reference number 2 and the forward microphone is indicated by reference number 4.

As can be seen in Fig. 2, the output of the rear microphone 2 is connected to the inverting input of an operational amplifier 10 through a capacitor 12 and a resistor 14, and the output of the front microphone 4 is connected to the non-inverting input of the operational amplifier 10 through a capacitor 16. A parallel RC circuit formed of resistor 18 and capacitor 20 forms a time delay circuit, which is connected between the output and the inverting input of the operational amplifier 10.

This circuit operates as follows, assuming that the microphones 2 and 4 have identical characteristics and that the components have been adjusted to appropriate values.

Because the distance between the sound source (not shown) is much larger than the distance between the rear and front microphones 2 and 4, the amplitudes at the outputs of the microphones 2 and 4 will be almost exactly equal. However, for sounds that come from the rear or from the front, there will be a phase difference between those amplitudes. This is because there will be a time delay between the time that the closer microphone produces an output signal and the time that the more remote microphone does so. In the ideal case, the RC time constant of the RC network formed by the resistor 18 and the resistor 20 is chosen to exactly compensate for this time delay when the sound comes from the rear and the values of the other components are chosen so that the signals at the inputs of the operational amplifier 10 are exactly equal. Thus, for sounds coming from the rear, the operational amplifier 10 ideally produces a zero output. (In practice, the operational amplifier 10 may actually produce a minimal, but nonzero, output.)

However, for sounds coming from the front, the RC network has the opposite effect: the above-referenced phase difference is not compensated, but is rather doubled. Hence, for sounds coming from the front, the output of the operational amplifier 10 is maximal. For sounds coming from the side, for which there is no phase difference between the outputs of the microphones 2 and 4, the output of the operational amplifier 10 is between the minimal and maximal outputs described above.

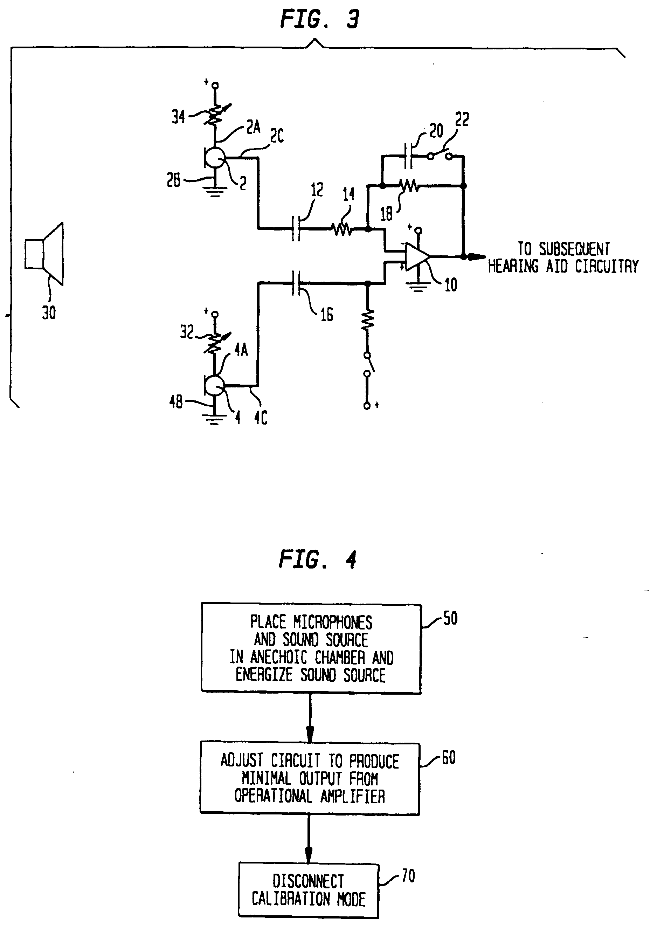

Fig. 3 illustrates circuitry that permits the use of microphones 2 and 4 that are not closely matched, and Fig. 4 illustrates the steps that are advantageously carried out during the calibration process. The circuitry makes use of switches 22 and 24, which may be programmable switches. When calibrating the circuit, the switch 22 is open and the switch 24 is closed; in use after calibration, the switch 22 is closed and the switch 24 is open.

The circuit is so designed that in the calibration mode the gains of the forward and rear channels are made identical, thereby nulling the output of the operational amplifier 10. When calibration commences, the loudspeaker 30 is energized (step 50) to produce a sound (advantageously, a 300-500 Hz sinusoidal signal). During this step 50, the loudspeaker 30 is aimed directly between the microphones 2 and 4 so the sound strikes the microphones 2 and 4 at the same time. (Advantageously, this is done in an anechoic chamber to reduce reflected sound signals. Likewise advantageously, the diameter of the loudspeaker 30 may be 3 to 4 inches and the distance between the loudspeaker 30 and the microphones 2 and 4 may be 12 to 15 inches.) Then, the resistors 32 and 34 (which may be programmable variable resistors) are adjusted in step 60 so that a minimum output is present at the output of the operational amplifier 10. Once this adjustment has been carried out, the switch 24 is opened, the switch 22 is closed, and the circuit is ready for use (step 70).

This calibration may be carried out before the hearing aid has been completed, or afterward.

Although the preferred embodiment uses an operational amplifier 10, this is not required. It is alternatively possible to use an adaptive signal processing circuit or a digital signal processing circuit instead.

## Claims

1. A microphone assembly for use in directional hearing aids, comprising:
first and second hearing aid microphones; and
a substrate, the microphones being mechanically fixed to the substrate.

2. The assembly of claim 1, wherein the substrate is a printed circuit and the microphones are electrically connected thereto.

3. The assembly of claim 1 or 2, further comprising electric components mounted to the substrate and being electrically connected thereto.

4. The assembly of claim 3, wherein the electric components include a time delay circuit.

5. The assembly of any preceding claim, wherein the substrate is of mylar.

6. The assembly of any preceding claim, wherein the substrate is of capton.

7. The assembly of claim 3 or of any claim dependent thereon, wherein the electric components include a circuit for modifying the characteristics of at least one of the microphones so the two microphones have matching characteristics.

8. The assembly of claim 7, wherein the circuit modifies at least one of the following characteristics: sensitivity, phase and frequency response.

9. A method for calibrating the assembly of claim 7 or 8, comprising the steps of connecting the microphones to inverting and non-inverting inputs of an operational amplifier and adjusting the circuit so the operational amplifier produces a minimum output in the presence of sound.

10. The method of claim 9, wherein said adjusting step is carried out with the microphones and a sound source in an anechoic chamber.
